(19) Europäisches Patentamt
European Patent Office
Office européen des brevets

(11) **EP 1 760 131 B1**

(12) **EUROPEAN PATENT SPECIFICATION**

(45) Date of publication and mention
of the grant of the patent:
**03.12.2008  Bulletin 2008/49**

(51) Int Cl.:
***C09J 7/02*** *(2006.01)*

(21) Application number: **06018447.0**

(22) Date of filing: **04.09.2006**

(54) **Pressure-sensitive adhesive sheet and method of processing articles**

Druckempfindliches Klebeblatt und Verfahren zum Bearbeiten von Gegenständen

Feuille adhésive sensible à la pression et procédé de traitement d'articles

(84) Designated Contracting States:
**DE**

(30) Priority: **06.09.2005  JP 2005257674**

(43) Date of publication of application:
**07.03.2007  Bulletin 2007/10**

(73) Proprietor: **NITTO DENKO CORPORATION**
**Ibaraki**
**Osaka 567-8680 (JP)**

(72) Inventors:
• **Yano, Kohei**
**Ibaraki**
**Osaka 567-8680 (JP)**

• **Akazawa, Kouji**
**Ibaraki**
**Osaka 567-8680 (JP)**
• **Yoshida, Yoshinori**
**Ibaraki**
**Osaka 567-8680 (JP)**
• **Kontani, Tomohiro**
**Ibaraki**
**Osaka 567-8680 (JP)**

(74) Representative: **Albrecht, Thomas et al**
**Kraus & Weisert**
**Patent- und Rechtsanwälte**
**Thomas-Wimmer-Ring 15**
**80539 München (DE)**

(56) References cited:
**EP-A2- 0 999 250          JP-A- 2004 107 644**

**Description**

BACKGROUND OF THE INVENTION

Field of the Invention

The present invention relates to a pressure-sensitive adhesive sheet and a method of processing an article using the same. In particular, it relates to a pressure-sensitive adhesive sheet used in a process of high-precision processing of semiconductor products and so on such as semiconductor wafers and optical products in order to hold or protect such products. Also, it relates to a method of processing an article using such a pressure-sensitive adhesive sheet.

Description of a Related Art

In some industrial fields such as optical industries and semiconductor industries, pressure-sensitive adhesive sheets are used in high-precision processing of optical parts such as lenses or semiconductor articles such as semiconductor wafers in order to protect the surface of wafers and the like or prevent breakage thereof.

For example, in the process of producing semiconductor chips, the semiconductor chips are produced as follows. First a high-purity silicon single crystal or the like is sliced to form wafers. A predetermined circuit pattern such as IC is formed on the wafer by etching to incorporate an integrated circuit. Then , the back side of the wafer is ground by a grinder to a thickness as thin as about 100 to about 600 $\mu$m. Finally, the wafer is diced into chips. Since the semiconductor wafer in itself is thin and brittle and the circuit pattern is uneven, the wafer tends to be broken if external force is applied to the wafer when it is transported to the steps of grinding and dicing. Consequently, to protect, for example, the circuit pattern surface and prevent breakage of the semiconductor wafer, it has been widely practiced to apply a pressure-sensitive adhesive sheet on the circuit pattern surface of the semiconductor wafer.

Example of a known pressure-sensitive adhesive sheet used here include pressure-sensitive adhesive sheets, for example, those including base sheets made of, for example, polyethylene terephthalate (PET), polyethylene (PE), polypropylene (PP), ethylene-vinyl acetate copolymers (EVA) having respective pressure-sensitive adhesive thereon.

However, in recent years, differences in height of unevenness of the surface of a circuit pattern on the wafer is increasing and on the other hand, thinner semiconductorwafers having thicknesses as thin as below 100 $\mu$m are being required for ultra-thin chips such as IC cards, stacked IC. Accordingly, in the case of a conventional pressure-sensitive adhesive sheet having a flexible base such as one made of EVA, the pressure-sensitive adhesive sheet can followup such unevenness of the surface of a circuit pattern without problems. However, since such a pressure-sensitive adhesive sheet has insufficient rigidity, wafers will be curled after their grinding or they will be bent due to their own weight. The curled or bent wafers can neither be transported by a conventional transporting system nor stored in a generally used special storage box for wafers.

Accordingly, a base may be conceived in which a rigid PET-based base and an flexible EVA-based base are bonded together. However, if these bases are mechanically bonded together through an adhesive, the stress given upon the lamination remains in the resultant film so that the bases will be curled. Further, when a laminate is formed by a T-die method or a calendering method, residual stress tends to occur in the film due to heat-shrinking upon the film formation. When a pressure-sensitive adhesive sheet with such a base in which residual stress has occurred is used in the production of wafers , wafers tend to be broken during grinding wafers or tend to cause unnegligible curles after grinding due to the strain in the pressure-sensitive adhesive sheet as a result of tensile stress, pressure and the like in affixing films together.

Various pressure-sensitive adhesive sheets are disclosed which are intended to decrease residual stress. For example, Japanese Patent Application Laid-open (kokai) No. 2000-150432 discloses a pressure-sensitive adhesive sheet having stress relaxation ratio at 10% elongation of 40%/mlnute or more in a tensile test. Japanese Patent Application Laid-open(kokai) No. 2003-261842 discloses a pressure-sensitive adhesive sheet that includes a base having a rigid film bonded to a stress-relaxed film through an adhesive layer. Japanese Patent Applications Laid-open (kokai) No. 2004-200451 and No. 2005-19518 disclose pressure-sensitive adhesive sheets that include apressure-sensitive adhesive layer on abase containing a unit layer with a specified elastic modulus in tension. Further, Japanese Patent Application Laid-open (kokai) No. 2002-69396 discloses a pressure-sensitive adhesive film for protecting semiconductor wafers, including outermost layers with a low elastic modulus and an inner layer having a low elastic modulus.

Further, Japanese Patent Applications Laid-open (kokai) No. 2004-107644 and No. 2004-122758 disclose pressure-sensitive adhesive sheets that include a composite film as a intermediate layer containing a urethane polymer and a vinyl-based polymer as active ingredients.

However, the above-mentioned pressure-sensitive adhesive sheets have problems of contaminants. Depending on the kind of the laminate film, laminating films having different elastic moduli in order to decrease residual stress may cause components of the film to bleed out and to migrate through the pressure-sensitive adhesive layer to the surface thereof, thus contaminating the surface of the adherend. Also, there occurs contamination of the surface of the adherend due to organic substances or particles from the pressure-sensitive adhesive.

After the dicing step in which a wafer is cut into chips, the wafer is wire-bonded, sealed with a resin and so on. Pressure-sensitive adhesive sheets used in these steps must not contaminate adherend such as a wafer by organic substances or particles derived from the pressure-sensitive adhesive that constitute the pressure-sensitive adhesive layer.

The contaminants on the surface of wafers are known to give adverse influence to the shear strength of thewire-bonding. That is, in the wire-bonding performed when a semiconductor chip is produced, the bonding strength between a ball and a pad is required to be high. Organic substances or particles attached to the surface of aluminum surface on the wafer are a factor that prevents bonding of gold wire onto the surface of aluminum. Further, when a large amount of contaminant is present on the surface of aluminum, the contaminant serves as a starting point from which voids grow, thus causing peeling-off of the sealant resin or cracks in the sealant resin, decreasing the shear strength of the wire-bonding.

On the other hand, pressure-sensitive adhesives that have been conventionally used include solvent-type acrylic-based pressure-sensitive adhesives. Since the solvent-type acrylic-based pressure-sensitive adhesives are synthesized in organic solvents, evaporation of the solvent upon their coating causes environmental pollution. Thus, conversion of them into aqueous dispersion-type acrylic-based pressure-sensitive adhesives is being attempted. However, since the aqueous dispersion-type acrylic-based pressure-sensitive adhesives contain an emulsifier in contrast to the solvent-type acrylic-based pressure-sensitive adhesives, they can not achieve bonding with low contamination.

In particular, with increasing requirements for higher density and higher performance of integrated semiconductor circuits in recent years, contamination on the circuit surface of semiconductor wafers and semiconductor chips obtained therefrom is controlled more strictly. Accordingly, a further improvement in low contamination property of the pressure-sensitive adhesive sheets used of processing of wafers is demanded.

The present invention has been made to solve the above-mentioned problems. Accordingly, it is an object of the present invention to provide a pressure-sensitive adhesive sheet, which can be used in the step of processing an article such as a semiconductor wafer, which does not cause breakage of a semiconductor wafer during grinding of the wafer even when the wafer is thin, which causes a wafer to show a less curl due to the residual stress of the pressure-sensitive adhesive sheet, which also has excellent anchoring power with the pressure-sensitive adhesive layer, and which can achieve low contamination. It is another object of the present invention to provide a method of processing an article by using such a pressure-sensitive adhesive sheet.

SUMMARY OF THE INVENTION

The present invention provides a pressure-sensitive adhesive sheet that has a base, an intermediate layer and a pressure-sensitive adhesive layer in order, wherein the intermediate layer has an elastic modulus in tension at 23°C of 10 MPa or more and 100 MPa or less, the intermediate layer includes an acrylic-based polymer obtained by polymerization of a mixture containing 70 to 99 parts by weight of a (meth)acrylate monomer and 1 to 30 parts by weight of an unsaturated carboxylic acid based on 100 parts by weight of total monomers, and the base includes at least one film having an elastic modulus in tension at 23°C of 0.6 GPa or more.

Here, the thickness of the intermediate layer may be 50 $\mu$m or more.

In the present invention, it is preferable that the intermediate layer is formed by curing the above-mentioned mixture of monomers by irradiation of radiation.

Further, the present invention provides a method of processing an article, which comprises performing high-precision processing an article in a held and/or protected state by applying any one of the above-mentioned pressure-sensitive adhesive sheets to the article to be high-precision-processed.

Here, it is preferable that the article to be high-precision-processed article is a semiconductor wafer, when the semiconductor wafer has a diameter of a (inch) and a thickness after the grinding of b ($\mu$m), the semiconductor wafer can be ground to have a value b/a ($\mu$m/inch) of 27 ($\mu$m/inch) or less.

DETAILED DESCRIPTION

The pressure-sensitive adhesive sheet of the present invention is a laminate that includes a base, an intermediate layer and a pressure-sensitive adhesive layer in this order. The intermediate layer has an elastic modulus in tension at 23°C of generally 10 MPa or more and 100 MPa or less, preferably 15 MPa or more and 80 MPa or less. When the elastic modulus in tension of the intermediate layer is 10 MPa or more and 100 MPa or less, the workability of affixing a pressure-sensitive adhesive sheet on the surface of an article in processing the article can be improved, and the workability of peeling the pressure-sensitive adhesive tape from the article after processing the article can be improved.

In the present invention, the term "elastic modulus in tension" of the intermediate layer refers to an initial elastic modulus that is obtained from an S-S curve prepared by fabricating a target (here, an intermediate layer, a pressure-sensitive adhesive layer or the like) to be measured having a thickness of 10 $\mu$m or more and 100 $\mu$m or less and cutting it to strips having a width of 10 mm to make samples, drawing the strip-shaped sample (1-cm-long portion) at 23°C at a speed of 50 mm/minute, and measuring elongation and plotting the results.

The intermediate layer includes an acrylic-based polymer obtained by polymerization of a mixture containing from 70 parts by weight to 99 parts by weight of a (meth)acrylate monomer and 1 part by weight to 30 parts by weight of an unsaturated carboxylic acid based on 100 parts by weight of total monomers. In the present invention, it is preferable that the blending amount of the unsaturated carboxylic acid that is used for forming the intermediate layer is 2 parts by weight or more and 25 parts by weight or less, and more preferably 3 parts by weight or more and 20 parts by weight or less. When the blending amount of the unsaturated carboxylic acid is less than 1 part by weight, the intermediate layer has poor adhesion with the pressure-sensitive adhesive layer. However, when the blending amount of the unsaturated carboxylic acid is more than 30 parts by weight, the elastic modulus of the intermediate layer increases abruptly, thus, the curl of the wafer after the grinding can not be effectively prevented.

When the monomer mixture is polymerized, it is preferable that a polymerization initiator is added and radiation is irradiated to form an intermediate layer. By copolymerizing unsaturated carboxylic acid, the adhesion between the intermediate layer and the pressure-sensitive adhesive layer, i.e., anchoring power can be increased due to the interaction between the polar component and nitrogen present in the pressure-sensitive adhesive.

When polar monomers other than the unsaturated carboxylic acids, for example, hydroxyl group-containing monomers or acrylic acid amide are copolymerized, the adhesion with the pressure-sensitive adhesive layer can be increased. However, low molecular weight components that are formed upon polymerization by irradiation of ultraviolet ray bleed out on the surface of the pressure-sensitive adhesive layer, thus causing contamination on the surface of an adherend, such as a wafer, on which the pressure-sensitive adhesive sheet is applied. In contrast, the intermediate layer formed by copolymerizing an unsaturated carboxylic acid as in the present invention does not cause bleeding out of the low molecular weight components onto the surface of the pressure-sensitive adhesive layer, even if they are formed during the polymerization. Although the reason for this is not clear, it is supposed that due to very high polarity of carboxylic group, unsaturated carboxylic acid is trapped by polar groups that are present in the pressure-sensitive adhesive layer, thus failing to bleed out onto the surface of the pressure-sensitive adhesive layer. On the other hand, presumably hydroxyl group-containing monomers and acrylic acid amides are not trapped by the polar groups in the pressure-sensitive adhesive layer, thus, they bleed out onto the surface of the pressure-sensitive adhesive layer.

Since a greater dose or a longer irradiation time will result in a faster completion of polymerization in polymerization by irradiation of ultraviolet ray, a greater dose of ultraviolet ray is preferable from the viewpoint of productivity. However, greater doses of ultraviolet ray lead to generation of more amounts of the low molecular weight components, which is disadvantageous from the viewpoint of contamination. For this reason, it is desired that no contamination should occur even if a large amount of low molecular weight components are generated, and it should be noted that the present invention can realize an intermediate layer that is free from contamination.

Examples of the (meth) acrylate monomer used to form the intermediate layer include (meth)acrylates such as methyl (meth)acrylate, ethyl (meth)acrylate, propyl (meth)acrylate, butyl (meth)acrylate, t-butyl (meth)acrylate, pentyl (meth)acrylate, hexyl (meth)acrylate, 2-ethylhexyl (meth)acrylate,octyl(meth)acrylate,isooctyl(meth)acrylate, nonyl (meth)acrylate, and isononyl (meth)acrylate.

The unsaturated carboxylic acids used to form the intermediate layer include monomers of carboxyl group-containing monomers or acid anhydrides thereof, such as acrylic acid, methacrylic acid, itaconic acid, maleic acid, crotonic acid, and maleic anhydride.

When forming the intermediate layer of the present invention, it is preferable that the reaction mixture contains a photopolymerization initiator in addition to the acrylate monomer and the unsaturated carboxylic acid. The photopolymerization initiators used in the present invention include $\alpha$-ketol-based compounds such as 4-(2-hydroxyethoxy)phenyl (2-hydroxy-2-propy) ketone, $\alpha$-hydroxy-$\alpha$,$\alpha$'- dimethylacetophenone, 2-methyl-2-hydroxypropiophenone, and 1-hydroxycyclohexyl phenyl ketone; acetophenone-based compounds such as methoxyacetophenone, 2,2-dimethoxy-2-phenylacetophenone, 2,2-diethoxyacetophenone, and 2-methyl-1-[4-(methylthio)phenyl]-2-morpholinopropane-1; benzoin ether based compounds such as benzoin ethyl ether, benzoin isopropyl ether, and anisole in methyl ether; ketal-based compounds such as benzyl dimethyl ketal; aromatic sulfonyl chloride based compounds such as 2-naphthalenesulfonyl chloride; optically active oxime based compounds such as 1-phenyl-1,1-propanedione-2-(o-ethoxycarbonyl)-oxim; benzophenone-based compounds such as benzophenone, benzoyl benzoate, and 3,3'-dimethyl-4-methoxybenzophenone; thioxanthone-based compounds such as thioxanthone, 2-chlorothioxanthone, 2-methylthioxanthone, 2,4-dimethylthioxanthone, isopropylthioxanthone, 2,4-dichlorothioxanthone, 2,4-diethyltioxanthone, and 2,4-diisopropylthioxanthone; camphor quinone; halogenated ketones; acyl phosphinoxides; acyl phosphonates and so on.

The blending amount of the photopolymerization initiator is preferably 0.01 parts by weight or more and 5 parts by weight or less, more preferably 0.1 part by weight or more and 3 parts by weight or less based on 100 parts by weight of a base polymer such as acrylic-based polymers that form the intermediate layer.

The intermediate layer may contain commonly used additives, for example, ultraviolet absorbents, antioxidants, fillers, pigments, colorants, flame retardants, and antistatic agents as necessary as far as they do not deteriorate the effects of the present invention. The additives may be used in amounts usually used depending on their kind.

To adjust the viscosity upon coating, the intermediate layer may contain a small amount of a solvent. The solvent may be selected appropriately from commonly used solvents, such as toluene, ethyl acetate, butyl acetate, acetone, methyl ethyl ketone, methyl isobutyl ketone, cyclohexanone, and cyclopentanone.

In the present invention, the intermediate layer may be formed by coating the mixture containing an acrylic-based monomer, an unsaturated carboxylic acid, and a photopolymerization initiator and so on as required on a base, and curing the mixture by irradiating radiation, foe example, ionizing radiation such as $\alpha$-ray, $\beta$-ray, $\gamma$-ray, neutron beam, or electron beam; and radiation such as ultraviolet ray, depending on the kind of the photopolymerization initiator used to form an intermediate layer. Also, the intermediate layer may be formed by coating the mixture on a base, superimposing a release-treated sheet (separator) or the like over the coating on the base, and irradiating radiation over through the separator to cure the coating.

In this case, to avoid inhibition of polymerization due to oxygen, the separator may be covered over the mixture of the acrylic-based monomer and unsaturated carboxylic acid coated on the base to shut out oxygen. Alternatively, the base may be placed in a vessel filled with an inert gas to decrease the concentration of oxygen in the atmosphere.

In the present invention, the kind of radiation and the kind of the lamp used for irradiation may be selected as appropriate. For example, for irradiation of ultraviolet ray, a high pressure mercury lamp, low pressure lamps such as a fluorescent chemical lamp and a black light, ultraviolet source such as excimer laser and a metal halide lamp, and an electron beam source can be used.

The dose of ultraviolet or the like may be set up optionally depending on the characteristics required for the intermediate layer. Generally, the dose of ultraviolet ray is selected within the range of preferably 200 to 10,000 mJ/cm$^2$. When the dose of ultraviolet ray is 200 mJ/cm$^2$ or more, a sufficient degree of polymerization can be obtained. When a dose of ultraviolet ray is 10,000 mJ/cm$^2$ or less, the characteristics of the intermediate layer will not be deteriorated.

Further, the temperature at which ultraviolet ray is irradiated is not particularly limited and can be set up optionally. However, when the temperature is too high, termination reaction tends to occur due to the heat of polymerization and thus cause a reduction in the characteristics of the intermediate layer. Usually, the temperature is 70˚C or less, preferably 50˚C or less, and more preferably 30˚C or less.

The thickness of the intermediate layer in the pressure-sensitive adhesive sheet of the present invention may be selected as appropriate depending on the purpose and the like. In particular, when the pressure-sensitive adhesive sheet is used for processing a high-precision component, the thickness of the intermediate layer is preferably 50 $\mu$m or more, more preferably 80 $\mu$m or more. The upper limit of the thickness of the intermediate layer is preferably 300 $\mu$m or less, more preferably 250 $\mu$m or less, and particularly preferably 200 $\mu$m or less.

The base that constitutes the pressure-sensitive adhesive sheet of the present invention has at least one layer that has an elastic modulus in tension at 23˚C of 0.6 GPa or more. This is because when the base has a high elastic modulus in tension, and hence, it is hard, curling of wafers can be effectively prevented. The elastic modulus in tension of the base is preferably 1 GPa or more from the viewpoint of improvement of the workability in affixing and peeling the pressure-sensitive adhesive sheet as well as the view point of prevention of curls after the grinding of wafers. Further, too high elastic modulus in tension of the base may cause trouble in peeling the pressure-sensitive adhesive sheet from the wafer. Accordingly, the elastic modulus in tension of the base is preferably 10 GPaorless. In the present invention, the term "elastic modulus in tension" of the base refers to an initial elastic modulus that is obtained from an S-S curve prepared by fabricating a target such as base to be measured having a thickness of 10 $\mu$m or more and 100 $\mu$m or less and cutting it to strips having a width of 10 mm to make samples, drawing the strip-shaped sample (1-cm-long portion) at 23˚C at a speed of 100 %/minute, measuring elongation and plotting the results.

As the base in the present invention, various films that are employed in general pressure-sensitive adhesive sheets for processing semiconductor wafers can be used. Note that the term "film" as used herein refers also to a sheet and the term "sheet" also refers to a film.

The materials that constitute the base include, for example, polyolefins such as low density polyethylenes, linear polyethylenes, medium density polyethylenes, high density polyethylenes, ultra-low density polyethylenes, random copolymer polyethylenes, block copolymer polypropylenes, homopolypropylenes, polybutenes, and polymethylpentenes; polyesters such as ethylene/vinyl acetate copolymers, ionomer resins, ethylene/(meth)acrylic acid copolymers, ethylene/(meth)acrylate (random, alternate) copolymers, ethylene/butene copolymers, ethylene/hexene copolymers, polyurethanes, polyethylene terephthalates, polybutylene terephthalates, and polyethylene naphthalates; polycarbonates; polyamides; polyimides; polystyrenes; polyether ether ketones, polyvinyl chlorides; polyvinylidene chlorides; fluororesins; cellulose-based resins; and crosslinked polymers thereof.

It is preferable that the material of film that constitutes the base is determined appropriately depending on the kind of the pressure-sensitive adhesive layers provided for a certain purpose and needs and so on. For example, when an ultraviolet-curing type pressure-sensitive adhesive is provided, a base having a high ultraviolet permeability is preferable. The base composed of such a material may not be drawn or may be monoaxially or biaxially drawn as necessary.

However, the base used in the present invention must contain at least one layer having an elastic modulus in tension at 23°C of 0.6 GPa or more. Examples of such a film include polyester films such as polyethylene terephthalate films, polybutylene terephthalate films, and polyethylene naphthalate films; polyolefin-based films such as biaxially drawn polypropylene films, and high density polyethylene films; polycarbonate films; drawn polyamide films; polyether ether ketone films; styrene-based polymer films such as polystyrene films; and so on.

The base may contain generally used additives as necessary as far as the effects of the present invention are not deteriorated. Examples of such additives include antioxidants, fillers, pigments, colorants, flame retardants, antistatic agents, and ultraviolet absorbents.

Further, in the present invention, conventional physical treatment or chemical treatment such as matte treatment, corona discharge treatment, primer treatment, crosslinking treatment (chemical crosslinking treatment with, for example, silane) may be performed to a surface of the base as necessary.

While it is preferable that the base used in the present invention has a greater thickness (in the case of a laminate, the total thickness is the thickness) in order to increase the rigidity of wafers, regarding the peeling-off workability in peeling the pressure-sensitive adhesive sheet after processing wafers or other articles, the thickness of the base is preferably about 10 μm or more and about 200 μm or less, more preferably about 50 μm or more and about 100 μm or less.

The pressure-sensitive adhesive sheet of the present invention has a pressure-sensitive adhesive layer on the intermediate layer.

Preferably, the pressure-sensitive adhesive layer that constitutes the pressure-sensitive adhesive sheet of the present invention has an elastic modulus in tension 0.1 GPa or less. The elastic modulus in tension of the pressure-sensitive adhesive layer can be adjusted by appropriately selecting the kind and composition of the base resins of the pressure-sensitive adhesive that constitutes the pressure-sensitive adhesive layer, the kind of crosslinking agent and so on, and blending ratios thereof. For example, the elastic modulus in tension of the pressure-sensitive adhesive layer can be adjusted by controlling the glass transition temperature (Tg) and crosslink density of the base polymer.

For the pressure-sensitive adhesive that constitutes the pressure-sensitive adhesive layer, for example, generally used pressure-sensitive adhesive can be used. More particularly, acrylic-based pressure-sensitive adhesives, rubber-based pressure-sensitive adhesives that contain rubber-based polymers such as natural rubber and styrene-based copolymers as basic polymer can be used. Among these adhesives, acrylic-based pressure-sensitive adhesives containing acrylic-based polymer as a base polymer is preferably used regarding the adhesion to semiconductor wafers and the ability to clean and wash the semiconductor wafers with super-pure water or organic solvents such as alcohols after peeling off the pressure-sensitive adhesive sheet.

Examples of the acrylic-based polymer include those acrylic-based polymers obtained by polymerizing a monomer component consisting of one or more monomers selected from the group consisting of alkyl (meth)acrylates (for example, linear or branched alkyl esters having 1 to 30 carbon atoms of alkyl group, preferably 4 to 18 carbon atoms such as methyl esters, ethyl esters, propyl esters, isopropyl esters, butyl esters, isobutyl esters, s-butyl esters, t-butyl esters, pentyl esters, isopentyl esters, hexyl esters, heptyl esters, octyl esters, 2-ethylhexyl esters, isooctyl esters, nonyl esters, dodecyl esters, isodecyl esters, undecyl esters, dodecyl esters, tridecyl esters, tetradecyl esters, hexadecyl esters, octadecyl esters, and eicosyl esters) and cycloalkyl (meth)acrylates (for example, cyclopentyl esters, cyclohexyl esters and so on) as monomer components.

Note that the term "(meth)acrylates" refers to acrylates and/or methacrylates (i.e., acrylates, methacrylates, or both acrylates and methacrylates). The term "(meth)" as used herein for all the occurrences shall be understood similarly.

The acrylic-based polymers may contain units corresponding to other monomer components that are copolymerizable with the alkyl (meth)acrylates or cycloalkyl (meth)acrylates in order to modify cohesive force, heat resistance and so on.

Examples of such a monomer component include carboxylic group-containing monomers such as acrylic acid, methacrylic acid, carboxyethyl (meth)acrylate, carboxypentyl (meth)acrylate, itaconic acid, maleic acid, fumaric acid, and crotonic acid; acid anhydride monomers such as maleic anhydride and itaconic anhydride; hydroxyl group-containing monomers such as 2-hydroxylethyl (meth)acrylate, 2-hydroxypropyl (meth)acrylate, 4-hydroxybutyl (meth)acrylate, 6-hydroxyhexyl (meth)acrylate, 8-hydroxyoctyl(meth)acrylate, 10-hydroxydecyl (meth)acrylate, 12-hydroxylauryl (meth)acrylate, and (4-hydroxymethylcyclohexyl)methyl (meth)acrylate; sulfonic group-containing monomers such as styrenesulfonic acid, allyl sulfonate, 2-(meth)acrylamide-2-methylpropanesulfonate, (meth)acrylamidepropanesulfonate, sulfopropyl (meth)acrylate, and (meth)acryloyloxynaphthalenesulfonate; phosphate group-containing monomers such as 2-hydroxyethylacryloyl phosphate; acrylamide, and acrylonitrile and so on.

These copolymerizable monomer components can be used singly or two or more of them can be used in combination. The amount of the copolymerizable monomers is preferably 40% by weight or less.

Further, the acrylic-based polymer may contain a polyfunctional monomer for crosslinking. Examples of the polyfunctional monomer include hexanediol di(meth)acrylate, (poly)ethylene glycol di(meth)acrylate, (poly)propylene glycol di(meth)acrylate, neopentyl glycol di(meth)acrylate, pentaerythritol di(meth)acrylate, trimethylolpropane tri(meth)acrylate, pentaerythritol tri(meth)acrylate, dipentaerythritol hexa(meth)acrylate, epoxy(meth)acrylate, polyester (meth)acrylate, and urethane (meth)acrylate.

Also, these polyfunctional monomers can be used singly or two or more of them can be used in combination. The amount of the polyfunctional monomer to be used is preferably 30% by weight or less based on the total monomer components from the viewpoint of adhesive properties.

The acrylic-based polymer can be obtained by polymerizing a mixture containing only one species of monomer or a mixture containing two or more species of monomer. The polymerization method for forming the acrylic-based polymer may be any of a solution polymerization method, an emulsion polymerization method, a mass polymerization method, a suspension polymerization method and so on.

The pressure-sensitive adhesive layer preferably contains a smaller amount of low molecular weight substances in order not to contaminate the affixing surface of the articles such as semiconductor wafers. From this viewpoint, the acrylic-based polymer has a number-average molecular weight on the order of, preferably 300,000 or more, and more preferably 400,000 to 3,000,000.

Further, to increase the number-average molecular weight of the acrylic-based polymer, an external crosslinking method can be adopted as appropriate. As such an external crosslinking method is exemplified a method in which the reaction is performed with adding a crosslinking agent such as a polyisocyanate compound, an epoxy compound, an aziridine compound, or a melamine-based crosslinking agent. The amount of the crosslinking agent used is determined depending on the balance with the base polymer to be polymerized and further on the purpose to use the pressure-sensitive adhesive. Generally, it is preferable that about 1 to about 5 parts by weight of the crosslinking agent is blended to 100 parts by weight of the base polymer. Further, the pressure-sensitive adhesive may contain various conventionally known additives such as tackifiers and antioxidants.

In the present invention, the pressure-sensitive adhesive that is used is preferably a radiation-curing type pressure-sensitive adhesive. For example, the radiation-curing type pressure-sensitive adhesive can be obtained by blending a tacky substance with anoligomer component that cures when irradiated with, radiation and so on to form a low-adherent substance. A pressure-sensitive adhesive sheet with its pressure-sensitive adhesive layer being formed with the radiation-curing type pressure-sensitive adhesive can be readily affixed to an article with ease since the pressure-sensitive adhesive is imparted plastic flowability by the oligomer component, and also the pressure-sensitive adhesive sheet can be readily released from the article such as a semiconductor wafer after the back-grinding step because of a low-adherent substance formed by irradiation of radiation in the adhesive.

A radiation-curing type pressure-sensitive adhesive that can be used has a radiation curable functional group such as a carbon-carbon double bond in the molecule thereof and exhibits tackiness, for example, an additive type radiation-curing type pressure-sensitive adhesive that is obtained by blending a conventional pressure-sensitive adhesive with a radiation curable monomer or oligomer component, and an intrinsic type radiation-curing type pressure-sensitive adhesive that contains a base polymer having a carbon-carbon double bond in the main chain or at the terminal or terminals of the main chain. Radiations that can be used to cure the pressure-sensitive adhesive layer include, for example, X-ray, electron beam, and ultraviolet ray and so on. It is preferable that ultraviolet ray is used in view of ease of handling. However, the present invention is not limited thereto.

As the general pressure-sensitive adhesive that constitutes the additive type radiation-curing type pressure-sensitive adhesive, pressure-sensitive adhesives such as the above-mentioned acrylic-based pressure-sensitive adhesives and rubber-based pressure-sensitive adhesives can be used.

Examples of the monomer having a radiation curable functional group include urethane oligomers, urethane (meth)acrylate, trimethylolpropane tri(meth)acrylate, tetramethylolmethane tetra(meth)acrylate, pentaerythritol tri(meth)acrylate, pentaerythritol tetra(meth)acrylate, dipentaerythritol monohydroxypenta(meth)acrylate, dipentaerythritol hexa (meth)acrylate, and 1,4-butanediol di(meth)acrylate and so on. On the other hand, radiation curable oligomer components include various oligomers such as urethane-based oligomers, polyether-based oligomers, polyester-basedoligomers, polycarbonate-basedoligomers, and polybutadiene-based oligomers. Those oligomers that have a molecular weight in the range of about 100 to about 30,000 are suitable. The blending amount of the monomer component or oligomer component having a radiation curable functional group is, for example, preferably about 5 to about 500 parts by weight, more preferably about 40 to about 150 parts by weight based on 100 parts by weight of the base polymer such as the acrylic-based polymer that constitutes the pressure-sensitive adhesive.

The intrinsic type radiation-curing type pressure-sensitive adhesives do not have to contain the oligomer component or the like that is a low polymerizing component and does not contain it much. Accordingly, there does not occur the situation in which the oligomer component or the like migrates in the pressure-sensitive adhesive with time, thus, a pressure-sensitive adhesive layer having a stable layer construction can be formed.

In the intrinsic type radiation-curing type pressure-sensitive adhesive, polymers that have a carbon-carbon double bond and have tackiness can be used as the base polymers without particular limitations. Such base polymers are preferably acrylic-based polymers in their basic skeleton. The acrylic-based polymers that are used here can be the same as those acrylic-based polymers already exemplified in the explanation of the acrylic-based pressure-sensitive adhesives.

The method of introducing a carbon-carbon double bond into an acrylic-based polymer as a basic skeleton is not particularly limited and various methods may be adopted. In the present invention for easy molecular design, it is preferable that the carbon-carbon double bond is introduced into side chain of the acrylic-based polymer to form a base polymer having a carbon-carbon double bond. Specifically, the carbon-carbon double bond can be introduced into side chain of the acrylic polymer, for example, by preliminarily copolymerizing an acrylic-based polymer with a monomer having a first functional group, and then reacting the resultant polymer with a compound having a carbon-carbon double bond and a second functional group that can react with the first functional group by a condensation or addition reaction such that the radiation curability of the carbon-carbon double bond is maintained.

Examples of combination of the functional group of amonomer to be copolymerized with the acrylic-based polymer and a functional group that can react with the functional group of the monomer are presented below. Such combinations include, for example, a carboxyl group and an epoxy group, a carboxyl group and an aziridyl group, a hydroxyl group and an isocyanate group, and so on. Among the combinations of functional groups, the combination of a hydroxyl group and an isocyanate group is preferable regarding easy trace of the reaction.

Further, in the presented combinations, any of the functional groups in the combination may be present on the acrylic-basedpolymeras the basic skelton. However, for example, in the combination of a hydroxyl group and an isocyanate group, it is preferable that the acrylic-based polymer has a hydroxyl group and the compound having a functional group that can react with the functional group of the monomer has an isocyanate group.

In this case, examples of the compound having an isocyanate group include methacryloyl isocyanate, 2-methacryloyloxyethyl isocyanate, and m-isopropenyl-$\alpha,\alpha$-dimethylbenzylisocyanate.

Examples of the acrylic-based polymer having a functional group (here, a hydroxyl group) include those acrylic-based polymers that are copolymerized with one or more compounds selected from the group comprising the above-mentioned hydroxyl group-containing monomers that have been exemplified in the description with respect to the acrylic-based pressure-sensitive adhesives and in addition 2-hydroxyethyl vinyl ether based compounds, 4-hydroxybutyl vinyl ether based compounds, and diethylene glycol monovinyl ether based compounds.

The intrinsic type radiation-curing type pressure-sensitive adhesive may be comprised singly by a base polymer having a carbon-carbon double bond (in particular acrylic-based polymer) but as far as its characteristics are not deteriorated, it may be blended with the above-mentioned radiation curable monomer component or oligomer component. The blending amount of the radiation curable monomer or oligomer component is in the range of usually 30 parts by weight or less, preferably 0 to 10 parts by weight based on 100 parts by weight of the base polymer.

The above-mentioned radiation curing type pressure-sensitive adhesives may contain a photopolymerization initiator when they are cured with radiation such as ultraviolet ray. Examples of the photopolymerization initiator include $\alpha$-ketol-based compounds such as 4-(2-hydroxyethoxy)phenyl (2-hydroxy-2-propyl) ketone, $\alpha$-hydroxy-$\alpha,\alpha$'-dimethyl-acetophenone, 2-methyl-2-hydroxypropiophenone, and 1-hydroxycyclohexyl phenyl ketone; acetophenone-based compounds such as methoxyacetophenone, 2,2-dimethoxy-2-phenylacetophenone, 2,2-diethoxyacetophenone, and 2-methyl-1-[4-(methylthio)-phenyl]-2-morpholinopropane-1; benzoin ether based compounds such as benzoin ethyl ether, benzoin isopropyl ether, and anisoin methyl ether; ketal-based compounds such as benzyl dimethyl ketal; aromatic sulfonyl chloride based compounds such as 2-naphthalenesulfonyl chloride; optically active oxime based compounds such as 1-phenone-1,1-propanedione-2-(o-ethoxycarbonyl)oxime; benzophenone-based compounds such as benzophenone, benzoyl benzoate, and 3,3'-dimethyl-4-methoxybenzophenone; thioxanthone-based compounds such as thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, and 2,4-diisopropylthioxanthone; camphorquinone, halogenated ketones, acyl phosphinoxides, and acyl phosphonates.

The amount of the photopolymerization initiator to be blended is, for example, about 1 to about 10 parts by weight, preferably about 3 to about 5 parts by weight based on 100 parts by weight of the base polymer such as acrylic-based polymer that constitutes the pressure-sensitive adhesive.

In the present invention, the pressure-sensitive adhesive to be used may be a thermal foaming type pressure-sensitive adhesive. The thermal foaming type pressure-sensitive adhesive is a pressure-sensitive adhesive that includes the above-mentioned pressure-sensitive adhesive with which thermally expandable minute particles are blended. The thermal foaming type pressure-sensitive adhesive when heated have a reduced contact area due to foaming of the thermally expandable minute particles by heat, which facilitates peeling of the pressure-sensitive adhesive sheet from the article to which it is affixed. The thermally expandable minute particles have an average particle diameter of preferably about 1 $\mu$m to about 25 $\mu$m, more preferably about 5 $\mu$m to about 15 $\mu$m, particularly preferably about 10 $\mu$m.

The thermally expandable minute particles are not particularly limited as far as they can expand under heating. For example, it is preferable to use thermally expandable microcapsules that are obtained by encapsulating a gaseous foamable component having a low boiling point, such as butane, propane, or pentane, by an in-site polymerization method in a shell of a copolymer such as vinylidene chloride or acrylonitrile. Such thermally expandable microcapsules have an advantage that they have excellent dispersibility with the above-mentioned pressure-sensitive adhesive. As the thermally expandable microcapsules, for example, "Microsphere", trade name for a product manufactured by Matsumoto Yushi Seiyaku Co., Ltd. is commercially available.

Preferably, the blending amount of the thermally expandable microcapsules is determined such that the adhesive force of the pressure-sensitive adhesive layer can be reduced appropriately depending on the kind of the pressure-sensitive adhesive and so on, and generally it is preferably about 1 part by weight to 100 parts by weight, more preferably 5 parts by weight to 50 parts by weight, and particularly preferably 10 parts by weight to 40 parts by weight based on 100 parts by weight of base polmer.

In the present invention, the pressure-sensitive adhesive layer may be formed by coating the above-mentioned pressure-sensitive adhesive optionally using a solvent or the like directly on the intermediate layer. Alternatively, it may be formed by coating the pressure-sensitive adhesive on a release liner or the like to form a pressure-sensitive adhesive layer in advance and then applying the pressure-sensitive adhesive layer on the intermediate layer.

The thickness of the pressure-sensitive adhesive layer is not particularly limited and can be determined appropriately, but, taking into consideration other characteristics of the pressure-sensitive adhesive sheet, the thickness is preferably about 5 $\mu$m to about 100 $\mu$m, and more preferably 15 $\mu$m to 50 $\mu$m.

The pressure-sensitive adhesive sheet of the present invention may be provided with a separator as necessary for protecting the pressure-sensitive adhesive layer. The separators include, for example, paper, and a plastic film. The materials for forming the plastic film include polyethylene , polypropylene, polyethylene terephthalate and so on. Preferably, the surface of the separator is subjected to releasing surface treatment such as silicone treatment, long-chain alkyl treatment, or fluorine treatment as necessary in order to increase releasability from the pressure-sensitive adhesive layer. Usually, the thickness of the separator is preferably about 10 $\mu$m to about 200 $\mu$m, and more preferably about 25 $\mu$m to about 100 $\mu$m.

The pressure-sensitive adhesive sheet of the present invention is used by a conventional method that is used when articles, for example, semiconductor wafers are processed. Here, an example case is presented where the pressure-sensitive adhesive sheet is used upon grinding the backside of a semiconductor wafer. In this case, first, a semiconductor wafer is mounted on a table such that a pattern surface, i.e. , a surface on which a pattern such as IC circuitry is provided is up and the pressure-sensitive adhesive sheet of the present invention is superimposed on the pattern surface such that the pressure-sensitive adhesive layer side contacts the pattern surface. Then, the pressure-sensitive adhesive sheet is affixed by pressing it by press means such as a press roll. Alternatively, the semiconductor wafer and the pressure-sensitive adhesive sheet are placed in a compressible vessel (for example, an autoclave) as superimposed in the above-mentioned manner and then the inner pressure of the vessel is increased to have the semiconductor wafer and the pressure-sensitive adhesive sheet affixed to each other. A press means may be used in combination. Alternatively, the semiconductor wafer and the pressure-sensitive adhesive sheet can be affixed to each other in a vacuum chamber. Alternative, the pressure-sensitive adhesive sheet can be affixed to the semiconductor wafer by heating the pressure-sensitive adhesive sheet to a temperature equal to or less than the melting point of the base of the pressure-sensitive adhesive sheet.

The method for polishing the backside of a semiconductor wafer is performed by a conventional polishing method. For example, a semiconductor wafer onto which a pressure-sensitive adhesive sheet is affixed in the above-mentioned manner is mounted on a polisher (back grinder) used as a processing machine for polishing and the backside of the wafer is polished to a desired thickness using a CMC (Chemical Mechanical Polishing) pad. When a pressure-sensitive adhesive sheet of which the pressure-sensitive adhesive layer is formed from the radiation-curing type pressure-sensitive adhesive is used, radiation is irradiated to the pressure-sensitive adhesive sheet after finishing polishing to decrease the adhesive strength of the pressure-sensitive adhesive layer. Then, the pressure-sensitive adhesive sheet can be peeled off from the wafer.

In the present invention, assuming that the semiconductor wafer has a diameter of "a (inch)" and a thickness after the grinding of "b ($\mu$m) " , back-grinding of the semiconductor wafer can be performed until a value b/a ($\mu$m/inch) of 27 ($\mu$m/inch) or less is reached. Therefore, according to the present invention, curl of the pressure-sensitive adhesive sheet can be reduced even when the wafer is made thinner. The curl of a wafer becomes serious in the case of low profile grinding. However, by performing back-grinding using the pressure-sensitive adhesive sheet of the present invention, the value of b/a can be made 27 ($\mu$m/inch) or less, thus, the curl of the wafer can be reduced even when the wafer is made thinner. For example, in the case of an 8-inch-diameter wafer, the curl of the wafer can be reduced even when the back-grinding is performed to a thickness of about 50 $\mu$m.

According to the present invention, a base having a high elastic modulus in tension is affixed to a semiconductor wafer with an intermediate layer having a low elastic modulus in tension being sandwiched therebetween, thus, the wafer as a whole has a suitable rigidity due to the interaction between the semiconductor wafer and the pressure-sensitive adhesive sheet, preventing the curl of the wafer after grinding effectively. Further, because of an intermediate layer having a low elastic modulus in tension, the pressure-sensitive adhesive sheet in itself is flexible, so, the affixing operation and peeling operation can be well performed. Here, it is significant to control the base and the intermediate layer to have respective specified elastic moduli at elongation.

Since the pressure-sensitive adhesive sheet of the present invention has an intermediate layer that is formed from an acrylic-based monomer and an unsaturated carboxylic acid, a pressure-sensitive adhesive sheet having sufficient anchoring power between the pressure-sensitive adhesive layer and the intermediate layer. Thus, low contamination can be achieved when the pressure-sensitive adhesive sheet is affixed to a surface of an article such as a wafer when grinding the article. After processing the wafer, the amount of the organic component that remains on the surface of the wafer is small, resulting in low contamination without causing wire bonding failure or breakage of sealant resin.

Further, according to the present invention, a pressure-sensitive adhesive sheet can be formed without using solvents such as MEK, thus, there arises no problem of environmental pollution.

EXAMPLES

Hereinafter, the present invention is explained by examples. However, the present invention is not limited thereto. In the following examples, all parts are parts by weight.

(Example 1)

In a reactor equipped with a condenser, a thermometer, and an agitator were charged 25 parts of butyl acrylate, 65 parts of t-butyl acrylate, and 5 parts of acrylic acid, and 0.3 parts of 2,2-dimethoxy-1,2-diphenylethan-1-one (registered trademark "IRGACURE 651," manufactured by Ciba Specialty Chemicals Co., Ltd.) as a photopolymerization initiator, and the mixture was exposed to ultraviolet ray to effect photopolymerization to a degree of polymerization of 10% to increase the viscosity to prepare a prepolymer having a viscosity adjusted so that it could be coated.

Then, the resultant prepolymer was coated on a 75-$\mu$m-thick polyethylene terephthalate (PET) film to a thickness after curing of 100 $\mu$m. On this was superimposed a release-treated separator, and ultraviolet ray (illuminance 5 mW/cm$^2$, light amount 300 mJ/cm$^2$) from a black light was irradiated to cure the coating to form an intermediate layer on the PET film. This PET film had an elastic modulus in tension at 23°C of 2 GPa.

Then, a blend of 97 parts of butyl acrylate, 3 parts of acrylic acid (AA), and 0.1 part of 2,2'-azobisisobutyronitrile (AIBN) was copolymerized in a toluene solution to obtain an acrylic-based copolymer having a weight-average molecular weight of $1.07 \times 10^6$ and a number-average molecular weight of $2.63 \times 10^5$. This was further mixed with 2 parts of a polyisocyanate-based crosslinking agent (trade name "CORONATE L," manufactured by NIPPON POLYURETHANE INDUSTRY CO., LTD.) and 2 parts of an epoxy-based crosslinking agent (trade name "TETRAD C," manufactured by MITSUBISHI GAS CHEMICAL COMPANY, INC.) based on 100 parts of solids of the acrylic-based copolymer solution to prepare a coating solution for a pressure-sensitive adhesive layer. The coating solution was coated on a release-treated separator to form a pressure-sensitive adhesive layer having a thickness of 30 $\mu$m. Then, the above-mentioned intermediate layer was superimposed and affixed onto the obtained pressure-sensitive adhesive layer to prepare a pressure-sensitive adhesive sheet having a layer construction of base/intermediate layer/pressure-sensitive adhesive layer/separator. The pressure-sensitive adhesive layer had an elastic modulus in tension at 23°C of 0.1 MPa.

(Example 2)

A pressure-sensitive adhesive sheet was prepared in the same manner as that in Example 1 except that in the step of forming the intermediate layer by irradiation of ultraviolet ray, the irradiation of ultraviolet ray was performed by using a metal halide lamp (5 mW/cm$^2$, 5,000 mJ/cm$^2$) instead of the black light.

(Example 3)

A pressure-sensitive adhesive sheet was prepared in the same manner as that in Example 1 except that 80 parts of butyl acrylate, 20 parts of acrylic acid, and 0.3 parts of IRGACURE 651 as a photopolymerization initiator were blended and allowed to react to form an acrylic polymer, which was coated on a base and irradiated with ultraviolet ray by using a metal halide lamp (5 mW/cm$^2$, 5,000 mJ/cm$^2$) instead of the black light to cure the intermediate layer.

(Comparative Example 1)

A pressure-sensitive adhesive sheet was prepared in the same manner as that in Example 1 except that the kind and amount of the material for forming the intermediate layer were changed to 30 parts of butyl acrylate, 70 parts of t-butyl acrylate, and 0.3 parts of IRGACURE 651 as a photopolymerization initiator.

(Comparative Example 2)

A pressure-sensitive adhesive sheet was prepared in the same manner as that in Example 1 except that the kind and amount of the material for forming the intermediate layer were changed to 25 parts of butyl acrylate, 65 parts of t-butyl acrylate, 10 parts of acryloylmorpholine (ACMO), and 0. 3 parts of IRGACURE 651 as a photopolymerization initiator, and the lamp for irradiation of ultraviolet ray was changed to a metal halide lamp (5 mW/cm$^2$, 5,000 mJ/cm$^2$).

(Comparative Example 3)

A pressure-sensitive adhesive sheet was prepared in the same manner as that in Example 1 except that the blending amounts of the materials for forming the acrylic polymer for the intermediate layer were changed to 25 parts of butyl acrylate, 65 parts of t-butyl acrylate, 10 parts of 2-hydroxyethyl acrylate (HEA), and 0.3 parts of IRGACURE 651 as a photopolymerization initiator, and the lamp for irradiation of ultraviolet ray in the formation of the intermediate layer was changed to a metal halide lamp (5 mW/cm$^2$, 5,000 mJ/cm$^2$).

(Comparative Example 4)

In a reactor equipped with a condenser, a thermometer, and an agitator were charged 10 parts of butyl acrylate, 25 parts of t-butyl acrylate, 15 parts of acrylic acid (AA), and 5 parts of trimethylolpropanetriol as radical polymerizing monomers, and 0.15 parts of 2,2-dimethoxy-1,2-diphenylpthan-1-one (registered trademark "IRGACURE 651," manufactured by Ciba Specialty Chemicals Co. , Ltd.) as a photopolymerization initiator, and 35 parts of polyoxytetramethylene glycol (molecular weight 650, manufactured by MITSUBISHI CHEMICAL COMPANY, INC.) as a polyol. While the mixture was being agitated, 15 parts of xylylene diisocyanate (XDI) was dripped therein, followed by reaction at 65°C for 2 hours to obtain a mixture of urethane polymer and an acrylic-based monomer. The amounts of the polyisocyanate component and the polyol component used were such that NCO/OH (equivalent ratio) = 1.10.
The mixture of the urethane polymer and the acrylic-based monomer was coated on a 75-μm-thick PET film to a thickness after curing of 100 μm. Over the mixture, ultraviolet ray (illuminance: 5 mW/cm$^2$, light amount: 5,000 mJ/cm$^2$) was irradiated by using a metal halide lamp to cure to form an intermediate layer on the PET film. The PET film had an elastic modulus in tension at 23°C of 2 GPa.

(Comparative Example 5)

A pressure-sensitive adhesive sheet was prepared in the same manner as that in Example 1 except that no intermediate layer was formed.

(Comparative Example 6)

A pressure-sensitive adhesive sheet was prepared in the same manner as that in Example 1 except that polybutylene terephthalate (PBT) was used as a resin for the intermediate layer and PBT was extruded on a PET film as a base and laminated (thickness of the intermediate layer: 100 μm; elastic modulus in tension: 1.1 GPa) to form a laminate.

<Evaluation Tests>

(1) Ratio (%) of polymers having a molecular weight of 100,000 or less

The intermediate layer was measured by gel permeation chromatography under the following conditions. The results were calculated in terms of "TSK Standard Polystyrene" to obtain a differential molecular weight curve. From ratios of areas of the obtained differential molecular weight curve, the contents of the components having molecular weights of 100,000 or less in the intermediate layer were obtained.

GPC apparatus: HLC-8120GPC, manufactured by TOSOH CORPORATION.
Column: GMH-H(S)/GMH-H(S)
Flow rate: 0.5 ml/min
Detector: HLC-8120
Concentration: 0.1 wt%
Injection amount: 100 μl
Eluant: THF

(2) Elastic modulus in tension

Intermediate layers having the same compositions as those in Examples 1 to 3 and Comparative Examples 1 to 6 were each combined with separators to form a layer construction of separator/intermediate layer/separator. After these were cut to strips having a size of 1 cm in width × 1 cm in length, and then the separators were removed from the strips to obtain samples consisting of only the intermediate layers. The samples were each drawn in the longitudinal direction at a drawing speed of 50 mm/min. Elongation of each sample was measured and the results were plotted to obtain an S-S curve to calculate an initial elastic modulus in tension, which was defined as an elastic modulus in tension of the sample. Various conditions required for the formation of the intermediate layers such as thickness and UV irradiation conditions adopted were the same as those used in the corresponding Examples and Comparative Examples.

(3) Evaluation of curl and cracks

Twenty (20) 8-inch wafers having a thickness of 625 μm were prepared. These wafers were affixed to the obtained pressure-sensitive adhesive sheets using a protecting tape affixing machine "DR-8500III" manufactured by NITTO SEIKI CO. , LTD. Each of the wafers with the pressure-sensitive adhesive sheet affixed thereto was ground to a thickness of 50 μm using a silicon wafer grinder manufactured by DISCO CORPORATION, and the resultant was evaluated as described below. Results obtained are shown in Table 1.

(i) Curls

Silicon wafers after the grinding with the pressure-sensitive adhesive sheet thereon were each left to stand on a flat plate so that the pressure-sensitive adhesive layer side up, and a distance between the most lifted up portion of the wafer (usually an edge of the wafer) and the surface of the flat plate was measured. The obtained distances were defined as curls. Then, an average of curls was calculated from measured values of 20 wafers. Silicon wafers having an average curl of 5 mm or less were judged to be fair, and wafers having an average curl of more than 8 mm were judged to be failure.

(ii) Cracks

Silicon wafers were observed during their grinding whether or not cracks occurred therein. When even only one wafer cracks, the evaluation of cracks was assigned a symbol "x", but when no cracks occurred in the wafer, the evaluation of cracks was assigned a symbol "○" based on judgment on five ground wafers.

(4)Evaluation of peelability

Using a mount peeler PM-8500 (manufactured by NITTO DENKO CORPORATION),a pressure-sensitive adhesive sheet was peeled from a ground wafer that had been ground in the same manner as in the case of the above-mentioned evaluation of curl and cracks in (3). Peelability was evaluated based on the following standards.

Evaluation standards:

○ : The pressure-sensitive adhesive sheet was peeled off without problems.
×: Peeling errors occurred to lead the machine to stop.

(5) Evaluation of contamination

The each obtained pressure-sensitive adhesive sheets was affixed to a silicon mirror wafer that was kept clean using a tap affixing machine "DR8500" manufactured by NITTO SEIKI CO., LTD. (affixing pressure: 2 MPa; affixing speed: 12 m/min). The resultant was left to stand in an atmosphere at 40°C for 24 hours. Thereafter, the pressure-sensitive adhesive sheet was peeled by using a tape peeling machine "HR8500" manufactured by NITTO SEIKI CO. , LTD. (peeling speed: 12 m/min; peeling angle: 180˚) . Organic substances, if any, transferred onto the wafer were measured by using an X-ray photoelectron spectrometer (XPS). Wafers having affixed thereon no pressure-sensitive adhesive sheet at all were also analyzed in the same manner as described above. Then, the amounts of the transferred organic substances were evaluated based on an increase in atomic % of the detected carbon atom. The atomic % of the carbon atom was calculated from respective elemental ratios (total 100%) of carbon, nitrogen, oxygen, silicon and so on. An increase in carbon ($\Delta C$) was compared with that in the state of the wafer before affixing thereon a pressure-sensitive adhesive sheet (blank) to obtain an index of contamination.

Note that the increase in carbon ($\Delta C$) was obtained according to the equation:

$$\Delta C = \text{(Amount of C on a surface of a wafer after peeling)}$$

$$- \text{(Amount of C on the surface of a blank wafer before affixing)}.$$

Here, when $\Delta C$ was 20% or less, contamination was judged to be low and the pressure-sensitive adhesive sheet was judged to be fair.

XPS apparatus: ESCA "Quantum 2000," manufactured by ULVAC-PHI, INC.
X-ray setting: Point analysis of 200-$\mu$m-diameter [30W (15 kV)]
X-ray source: Monochromatic Alk$\alpha$
Photoelectron takeoff angle: 45˚
Vacuum degree: $5 \times 10^{-9}$ torr
Neutralizing condition: Neutralization gun and ion gun (neutralization mode)in combination
For narrow scan spectra, the peak ascribable to the C-C bond of Cls was amended to 285.0 eV.

(6) Anchoring power

A 50-$\mu$m-thick PET tape was affixed on the side of the pressure-sensitive adhesive layer of the obtained pressure-sensitive adhesive sheet, and was applied T-peeling (a peeling method in which respective ends of a pressure-sensitive adhesive sheet and of a PET tape were drawn in opposite directions at 180˚ to peel on the interface between the pressure-sensitive adhesive sheet and the intermediate layer so that the angle between the pressure-sensitive adhesive sheet and the intermediate layer was about 180˚). Then, peeling power in that state was measured. Note that the anchoring power is preferably 3 N or more taking practical utility into consideration.

Table 1

| | Intermediate layer | | | | Evaluation | | | | |
|---|---|---|---|---|---|---|---|---|---|
| | Material (Part) | | Ratio of MW ≤ 100,000 | Elastic modulus in tension | Curl | Cracks | Peelability | Contamination | Anchoring power |
| | | Polar component | (%) | (MPa) | (mm) | | | (%) | (N/20mm) |
| Example 1 | Acrylic | AA (5) | 16.4 | 58 | 4 | O | O | 10 | 3.7 |
| Example 2 | Acrylic | AA (5) | 42 | 38 | 4 | O | O | 11 | 3.9 |
| Example 3 | Acrylic | AA (20) | 40 | 35 | 4 | O | O | 11 | 6 |
| Comparative Example 1 | Acrylic | - | 42 | 37 | 4 | O | O | 10 | 2 |
| Comparative Example 2 | Acrylic | ACMO (10) | 34 | 20 | 4 | O | O | 24 | 6 |
| Comparative Example 3 | Acrylic | HEA (10) | 40 | 63 | 4 | O | O | 28 | 2.4 |
| Comparative Example 4 | Acrylic Urethane | - | - | 11 | 4 | O | O | 25 | 3.2 |
| Comparative Example 5 | - | - | - | - | 6 | O | O | 11 | 7 |
| Comparative Example 6 | PBT | - | - | 1100 | 4 | × | × | 11 | 7 |

14

Table 1 indicates that the wafers processed using the pressure-sensitive adhesive sheets of Examples 1 to 3 of the present invention showed curls of 5 mm or less and caused no problem to occur during transportation to subsequent processing steps. Further, wafers were processed by grinding them to a thickness of 50 $\mu$m using the pressure-sensitive adhesive sheets of Examples 1 to 3, then, none of the wafers showed cracks. Also, after the grinding the pressure-sensitive adhesive sheets could be peeled from the wafers without problems. Furthermore, the pressure-sensitive adhesive sheets of Examples 1 to 3 showed good results in the evaluation of anchoring power, indicating that they caused no adhesive deposit on the adherend such as wafers, enabling to realize processing with low contamination. In particular, according to the present invention, as shown in, for example, Examples 2 and 3, low contamination could be realized with the pressure-sensitive adhesive containing a relatively high ratio of the polymer having a molecular weight of 100 , 000 or less. Since low contamination is realized, there occurred neither wire bonding failure nor breakage of the sealant resin.

On the other hand, Comparative Example 1, in which no polar monomer was used, had poor anchoring power. It is indicated that the pressure-sensitive adhesive sheet of Comparative Examples 2 and 3 in which ACMO or HEA was adopted as the polar monomer as well as the pressure-sensitive adhesive sheet of Comparative Example 4 in which an intermediate layer containing a urethane component was formed showed high contamination on a wafer. Further, the pressure-sensitive adhesive sheet of Comparative Example 5 without an intermediate layer showed a curl of 5 mm or more. Also, the pressure-sensitive adhesive sheet of Comparative Example 6 that had an intermediate layer having an elastic modulus in tension of 1.1 GPa showed cracks during the grinding and also peeling failure during the peeling.

According to the present invention, a pressure-sensitive adhesive sheet used in processing an article such as a semiconductor wafer and optical articles and a method of processing an article using such a pressure-sensitive adhesive sheet, which can prevent the breakage of the article and cause no substantial curl, which can exhibit excellent anchorage with the pressure-sensitive adhesive layer, and which can achieve low contamination. For example, when a semiconductor wafer is affixed to the pressure-sensitive adhesive sheet and polished to a thin film, the wafer is not damaged. In addition, since the curl of the wafer due to the residual stress in the pressure-sensitive adhesive sheet can be decreased, the finished wafers can be stored in a sole-use storage case.

[Industrial Applicability]

The pressure-sensitive adhesive sheets of the present invention can be advantageously used as a pressure-sensitive adhesive sheet used for processing semiconductor wafers when the backside of semiconductor wafers is ground or semiconductor wafers are diced. Further, it causes no interface fracture between the surface of aluminum and gold wire in wire bonding performed at the time of manufacturing semiconductor chips, thus enabling the wafer to maintain a high shear strength. Furthermore, taking the advantage of its characteristic of low contamination, the pressure sensitive adhesive sheet can be used in a variety of applications in which the pressure - sensitive adhesive sheet is peeled during or after its use. For example, the pressure-sensitive adhesive sheet is widely used for protecting the surface of articles or for preventing breakage of the articles in the manufacture of high-precision processed parts, for example, various engineering materials, in particular semiconductors, circuits, various printed boards, various masks, and lead frames.

**Claims**

1.  A pressure-sensitive adhesive sheet, comprising:

    a base, an intermediate layer, and a pressure-sensitive adhesive layer in this order;
    wherein the intermediate layer has an elastic modulus in tension at 23°C of 10 MPa or more and 100 Mpa or less, the intermediate layer includes an acrylic-basedpolymer obtained by polymerization of a mixture containing 70 to 99 parts by weight of a (meth) acrylate monomer and 1 to 30 parts by weight of an unsaturated carboxylic acid based on 100 parts by weight of the total monomers; and the base includes at least one film having an elastic modulus in tension at 23°C of 0.6 GPa or more.

2.  The pressure-sensitive adhesive sheet as claimed in claim 1. wherein the thickness of the intermediate layer is 50 $\mu$m or more.

3.  The pressure-sensitive adhesive sheet as claimed in claim 1. wherein the intermediate layer is formed by curing the mixture by irradiation of radiation.

4.  The pressure-sensitive adhesive sheet as claimed in claim 3, wherein the radiation is ultraviolet ray, and a dose of ultraviolet ray is 200 mJ/cm$^2$ or more and 10,000 mJ/cm$^2$ or less.

5. The pressure-sensitive adhesive sheet as claimed in claim 1, wherein the base has a thickness of 10 $\mu$m or more and 200 $\mu$m or less.

6. The pressure-sensitive adhesive sheet as claimed in claim 2, wherein the intermediate layer is formed by curing the mixture by irradiation of radiation.

7. A method of processing an article, comprising:

affixing a pressure-sensitive adhesive sheet to an article,
and performing high-precision processing of the article in a held or protected state;
wherein the pressure-sensitive adhesive sheet, having a base, an intermediate layer, and a pressure-sensitive adhesive layer in this order, and wherein the intermediate layer has an elastic modulus in tension at 23˚C of 10 MPa or more and 100 Mpa or less, the intermediate layer includes an acrylic-based polymer obtained by polymerization of a mixture containing 70 to 99 parts by weight of a (meth)acrylate monomer and 1 to 30 parts by weight of an unsaturated carboxylic acid based on 100 parts by weight of the total monomers, and the base includes at least one film having an elastic modulus in tension at 23˚C of 0.6 GPa or more.

8. The method of processing an article as claimed in claim 7, wherein the article to be high-precision-processed is a semiconductor wafer, and assuming the semiconductor wafer has a diameter of a (inch) and a thickness after grinding of b ($\mu$m), the semiconductor wafer can be ground until a value b/a ($\mu$m/inch) of 27 ($\mu$m/inch) or less.

9. The method of processing an article as claimed in claim 7, wherein the intermediate layer has the thickness of 50 $\mu$m or more.

10. The method of processing an article as claimed in claim 7, wherein the intermediate layer is formed by curing the mixture by irradiation of radiation.

11. The method of processing an article as claimed in claim 10, wherein the radiation is ultraviolet ray, and a dose of ultraviolet ray is 200 mJ/cm$^2$ or more and 10,000 mJ/cm$^2$ or less.


**Patentansprüche**

1. Druckempfindliche Klebefolie, umfassend:

eine Basis, eine Zwischenschicht und eine druckempfindliche Klebeschicht in dieser Reihenfolge; wobei die Zwischenschicht einen Zugelastizitätsmodul bei 23˚C von 10 MPa oder mehr und 100 MPa oder weniger besitzt, die Zwischenschicht ein acrylbasiertes Polymer umfasst, erhalten durch Polymerisation einer Mischung, enthaltend 70 bis 99 Gewichtsteile eines (Meth)acrylatmonomers und 1 bis 30 Gewichtsteile einer ungesättigten Carbonsäure, bezogen auf 100 Gewichtsteile der gesamten Monomere; und die Basis umfasst mindestens einen Film mit einem Zugelastizitätsmodul bei 23˚C von 0,6 GPa oder mehr.

2. Druckempfindliche Klebefolie gemäß Anspruch 1, wobei die Dicke der Zwischenschicht 50 $\mu$m oder mehr beträgt.

3. Druckempfindliche Klebefolie gemäß Anspruch 1, wobei die Zwischenschicht durch Härten der Mischung durch Bestrahlung mit Strahlen gebildet wird.

4. Druckempfindliche Klebefolie gemäß Anspruch 3, wobei die Strahlen Ultraviolettstrahlen sind und die Dosis der Ultraviolettstrahlen 200 mJ/cm$^2$ oder mehr und 10.000 mJ/cm$^2$ oder weniger beträgt.

5. Druckempfindliche Klebefolie gemäß Anspruch 1, wobei die Basis eine Dicke von 10 $\mu$m oder mehr und 200 $\mu$m oder weniger aufweist.

6. Druckempfindliche Klebefolie gemäß Anspruch 2, wobei die Zwischenschicht durch Härten der Mischung durch Bestrahlung mit Strahlen gebildet wird.

7. Verfahren zum Verarbeiten eines Artikels, umfassend:

Fixieren einer druckempfindlichen Klebefolie auf einem Artikel und Durchführen einer Hochpräzisionsverarbeitung des Artikels in festgehaltenem oder geschütztem Zustand;
wobei die druckempfindliche Klebefolie eine Basis, eine Zwischenschicht und eine druckempfindliche Klebeschicht in dieser Reihenfolge besitzt, und wobei die Zwischenschicht einen Zugelastizitätsmodul bei 23˚C von 10 MPa oder mehr und 100 MPa oder weniger besitzt, die Zwischenschicht ein acrylbasiertes Polymer umfasst, erhalten durch Polymerisation einer Mischung, enthaltend 70 bis 99 Gewichtsteile eines (Meth)acrylatmonomers und 1 bis 30 Gewichtsteile einer ungesättigten Carbonsäure, bezogen auf 100 Gewichtsteile der gesamten Monomere, und die Basis mindestens einen Film mit einem Zugelastizitätsmodul bei 23˚C von 0,6 GPa oder mehr umfasst.

8. Verfahren zum Verarbeiten eines Artikels gemäß Anspruch 7, wobei der durch Hochpräzisionsverarbeitung zu verarbeitende Artikel ein Halbleiter-Wafer ist, und, unter der Annahme, dass der Halbleiter-Wafer einen Durchmesser von a (Inch) und eine Dicke b ($\mu$m) nach dem Schleifen besitzt, der Halbleiter-Wafer bis zu einem Wert b/a ($\mu$m/Inch) von 27 ($\mu$m/Inch) oder weniger geschliffen werden kann.

9. Verfahren zum Verarbeiten eines Artikels gemäß Anspruch 7, wobei die Zwischenschicht eine Dicke von 50 $\mu$m oder mehr aufweist.

10. Verfahren zum Verarbeiten eines Artikels gemäß Anspruch 7, wobei die Zwischenschicht durch Härten der Mischung durch Bestrahlung mit Strahlen gebildet wird.

11. Verfahren zum Verarbeiten eines Artikels gemäß Anspruch 10, wobei die Strahlen Ultraviolettstrahlen sind, und die Dosis der Ultraviolettstrahlen 200 mJ/cm$^2$ oder mehr und 10.000 mJ/cm$^2$ oder weniger beträgt.

**Revendications**

1. Feuille adhésive sensible à la pression comprenant :

une base, une couche intermédiaire, et une couche adhésive sensible à la pression, dans cet ordre ;
dans laquelle la couche intermédiaire présente un module d'élasticité en tension à 23 ˚C de 10 MPa ou plus et de 100 MPa ou moins, la couche intermédiaire comprend un polymère à base d'acrylique obtenu par polymérisation d'un mélange contenant 70 à 99 parties en poids d'un monomère de (méth)acrylate et 1 à 30 parties en poids d'un acide carboxylique insaturé, sur la base de 100 parties en poids du total des monomères ; et la base comprend au moins un film ayant un module d'élasticité en tension à 23 ˚C de 0,6 GPa ou plus.

2. Feuille adhésive sensible à la pression telle que revendiquée dans la revendication 1, dans laquelle l'épaisseur de la couche intermédiaire est de 50 $\mu$m ou plus.

3. Feuille adhésive sensible à la pression telle que revendiquée dans la revendication 1, dans laquelle la couche intermédiaire est formée en durcissant le mélange par exposition à un rayonnement.

4. Feuille adhésive sensible à la pression telle que revendiquée dans la revendication 3, dans laquelle le rayonnement est un rayonnement ultraviolet, et une dose de rayonnement ultraviolet est de 200 mJ/cm$^2$ ou plus et de 10 000 mJ/cm$^2$ ou moins.

5. Feuille adhésive sensible à la pression telle que revendiquée dans la revendication 1, dans laquelle la base a une épaisseur de 10 $\mu$m ou plus et de 200 $\mu$m ou moins.

6. Feuille adhésive sensible à la pression telle que revendiquée dans la revendication 2, dans laquelle la couche intermédiaire est formée en durcissant le mélange par exposition à un rayonnement.

7. Procédé de traitement d'un article, comprenant les étapes consistant à :

fixer une feuille adhésive sensible à la pression sur un article,
et réaliser un traitement haute précision de l'article dans un état maintenu ou protégé ;

dans lequel la feuille adhésive sensible à la pression, a une base, une couche intermédiaire et une couche adhésive sensible à la pression, dans cet ordre, et dans lequel la couche intermédiaire présente un module d'élasticité en tension à 23 ˚C de 10 MPa ou plus et de 100 MPa ou moins, la couche intermédiaire comprenant un polymère à base d'acrylique obtenu par polymérisation d'un mélange contenant 70 à 99 parties en poids d'un monomère de (méth)acrylate et 1 à 30 parties en poids d'un acide carboxylique insaturé, sur la base de 100 parties en poids du total des monomères ; et la base comprend au moins un film ayant un module d'élasticité en tension à 23 ˚C de 0,6 GPa ou plus.

8.  Procédé de traitement d'un article tel que revendiqué dans la revendication 7, dans lequel l'article à traiter avec une haute précision est une tranche de semi-conducteur, et en supposant que la tranche de semi-conducteur a un diamètre a (pouce) et une épaisseur après meulage b ($\mu$m), la tranche de semi-conducteur peut être meulée jusqu'à une valeur b/a ($\mu$m/pouce) de 27 ($\mu$m/pouce) ou moins.

9.  Procédé de traitement d'un article tel que revendiqué dans la revendication 7, dans lequel l'épaisseur de la couche intermédiaire est de 50 $\mu$m ou plus.

10. Procédé de traitement d'un article tel que revendiqué dans la revendication 7, dans lequel la couche intermédiaire est formée en durcissant le mélange par exposition à un rayonnement.

11. Procédé de traitement d'un article tel que revendiqué dans la revendication 10, dans lequel le rayonnement est un rayonnement ultraviolet, et une dose de rayonnement ultraviolet est de 200 mJ/cm$^2$ ou plus et de 10 000 mJ/cm$^2$ ou moins.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000150432 A
- JP 2003261842 A
- JP 2004200451 A
- JP 2005019518 A
- JP 2002069396 A
- JP 2004107644 A
- JP 2004122758 A